# EUROPEAN PATENT SPECIFICATION

(11) **EP 4 117 409 B1**
(45) Date of publication and mention of the grant of the patent: **27.03.2024**
(21) Application number: 20922614.1
(22) Date of filing: 05.03.2020
(51) Int. Cl.: H05K 13/04, H05K 13/08

(54) **COMPONENT MOUNTER**
KOMPONENTENMONTIERER
DISPOSITIF DE MONTAGE DE COMPOSANTS

(43) Date of publication of application: 11.01.2023
(73) Proprietor: FUJI Corporation, Chiryu-shi, Aichi 472-8686 (JP)
(72) Inventor: KOTANI, Kazuya, Chiryu-shi, Aichi 472-8686 (JP); ONO, Keiichi, Chiryu-shi, Aichi 472-8686 (JP); FUJIMOTO, Tomoya, Chiryu-shi, Aichi 472-8686 (JP)
(74) Representative: Grünecker Patent- und Rechtsanwälte PartG mbB
(86) International application number: PCT/JP2020/009294
(87) International publication number: WO 2021/176626

(56) References cited:
- WO-A1-2014/128913
- DE-A1-102013 102 046
- JP-A- 2008 060 543
- JP-B2- 6 628 050
- US-B2- 10 299 418

## Description

### Technical Field

The present invention relates to a component mounter.

### Background Art

A component mounter executes a mounting process of mounting components supplied by a bulk feeder or the like on a board. A bulk feeder is used to supply components accommodated in a bulk state. In types of bulk feeders, there is a type, as shown in JP 2011 114084 A, for supplying components in a bulk state in which components are scattered in a supply area where a suction nozzle can pick up the components so supplied. In a mounting process, a component mounter executes image processing of recognizing a supply state of components by such a bulk feeder, and controls a pickup operation of picking up a component using a suction nozzle based on the result of the image processing. In a component mounter of JP 2008 060543 A, components are supplied by tape feeders. Operating times of a mounting head with four suction nozzles can be reduced by mounting four components that have the same or similar mounting angles with the mounting head, so that the rotation of the suction nozzles during mounting is minimized. In a component mounter disclosed in DE 10 2013 102046 A1, a drum picks up components from a bulk feeder, a sensor unit determines the position and the orientation of supplied components on the drum, and a comparison device determines whether the position and the orientation of the component on the drum are appropriate to be picked up by a mounting head.

### Summary of the Invention

### Technical Problem

In a PP cycle (pick-and-place cycle) which is repeatedly executed by a component mounter in a mounting process, a number of components corresponding to the number of suction nozzles supported on a mounting head are collected from a supply area of a bulk feeder, and these components can be sequentially mounted in predetermined mounting positions at predetermined mounting angles on a board. In such a mounting process, it is desired to shorten a required time for each PP cycle.

An object of the present description is to provide a component mounter which can match a configuration in which multiple components are supplied in a bulk state and shorten a required time for a PP cycle by executing efficiently a component pickup operation and a component mounting operation which are executed multiple times in the PP cycle.

### Solution to Problem

The problem is solved by a component mounter as defined in claim 1.

### Advantageous Effect of the Invention

With this configuration, the components to be a pickup target in the supply area and the pickup order are set based on the mounting angle for each mounting operation in addition to the supply state including the orientations of the components in the supply area. This enables the components to be picked up in the suitable orientations for the mounting operation. As a result, the pickup operation and the mounting operation can be made efficient, thereby making it possible to shorten a required time for the PP cycle.

### Brief Description of Drawings

[Fig. 1] A schematic diagram illustrating a configuration of a component mounter.
[Fig. 2] A top view schematically illustrating a mounting head.
[Fig. 3] A side view schematically illustrating the mounting head.
[Fig. 4] A diagram illustrating multiple components which are supplied to a supply area in a bulk state.
[Fig. 5] A block diagram illustrating a control device of the component mounter.
[Fig. 6] A diagram illustrating image data used for recognition processing of a supply state of components in the supply area.
[Fig. 7] A diagram illustrating a mounting movement and a mounting rotation in a mounting operation which is executed multiple times.
[Fig. 8] A diagram illustrating a required time of execution of multiple mounting operations each including the mounting movement and the mounting rotation.
[Fig. 9] A diagram illustrating a required time of execution of multiple pickup operations each including a pickup movement and a preliminary rotation.
[Fig. 10] A diagram illustrating movement path candidates for the mounting head in the multiple pickup operations.
[Fig. 11] A diagram illustrating required times of a pickup operation and a mounting operation for each pickup target candidate.
[Fig. 12] A diagram illustrating multiple supply area candidates, which are divided into multiple partitions, and multiple movement path candidates.
[Fig. 13] A flowchart illustrating mounting processing by the component mounter.

### Description of Embodiments

### 1. Configuration of Component Mounter 10

Component mounter 10 makes up a production line for producing board products together with multiple types of board work machines including, for example, another component mounter 10. The board work machines making up the production line described above can include a printer, an inspection device, a reflow furnace, and the like.

### 1-1. Board Conveyance Device

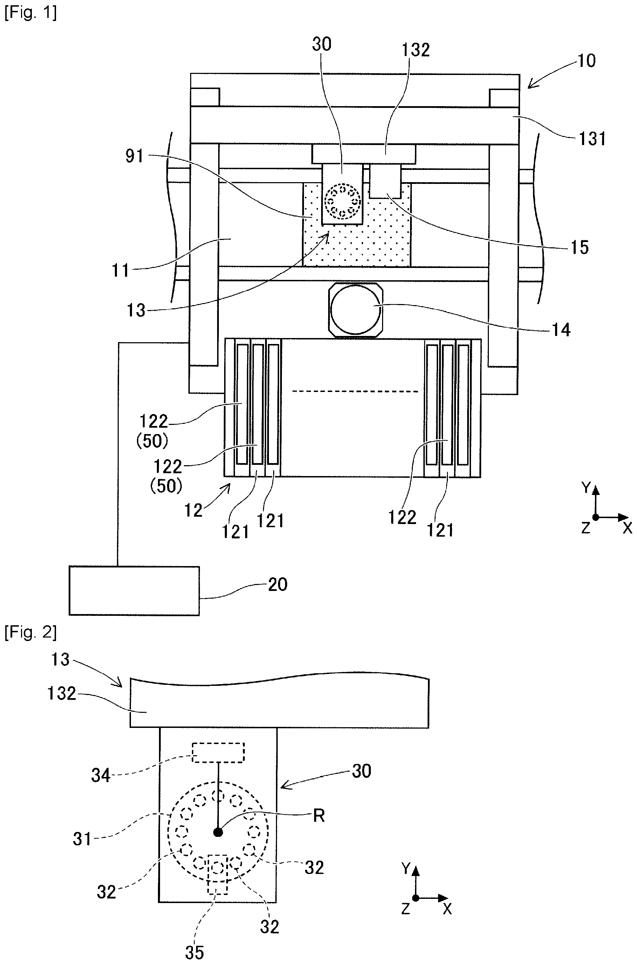

As illustrated in Fig. 1, component mounter 10 includes board conveyance device 11. Board conveyance device 11 sequentially conveys board 91 in a conveyance direction and positions board 91 in a predetermined position in component mounter 10.

### 1-2. Component Supply Device 12

Component mounter 10 includes component supply device 12. Component supply device 12 supplies components to be mounted on board 91. Component supply device 12 includes feeders 122 which are equipped individually in multiple slots 121. A tape feeder, which is configured to feed and move a carrier tape accommodating, for example, a number of components so as to supply the components to be picked up, is applied to feeder 122. In addition, bulk feeder 50, which is configured to supply components accommodated therein in a bulk state (a loose state in which individual components are oriented irregularly) to be picked up, is applied to feeder 122.

Bulk feeder 50 is installed in component mounter 10 to function as at least a part of component supply device 12. Since, unlike the tape feeder, bulk feeder 50 does not use a carrier tape, using bulk feeder 50 provides an advantage in that loading of a carrier tape, recovery of a carrier tape which is used up, or the like can be omitted. On the other hand, since bulk feeder 50 supplies components 92 which are accommodated therein in a bulk state in which the components are not aligned as in a carrier tape, using bulk feeder 50 can affect a pickup operation in such a way that a holding member is required to move to pick up components 92 in accordance with supplied states of relevant components 92.

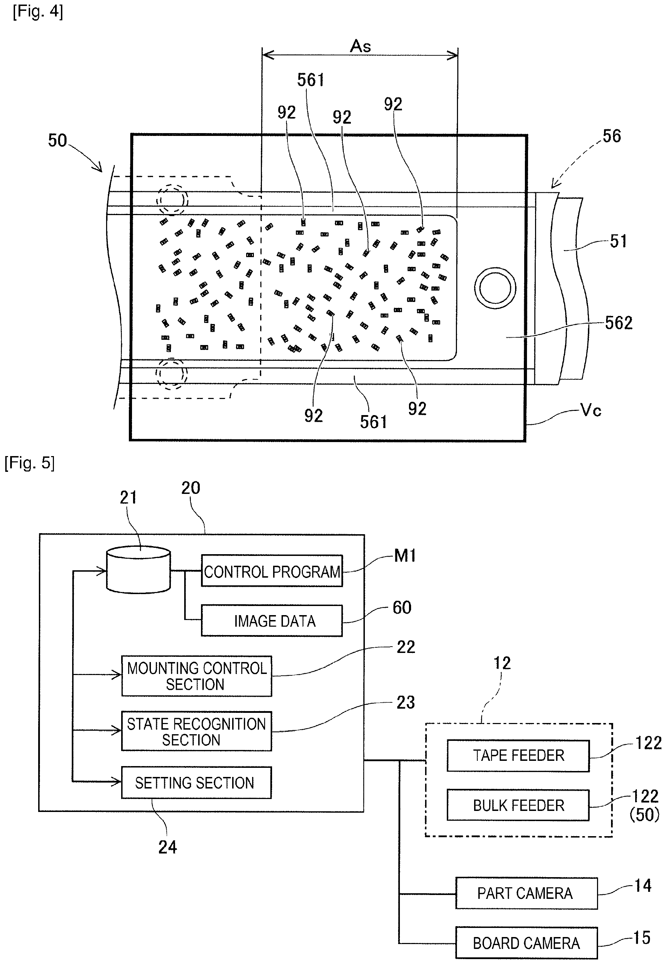

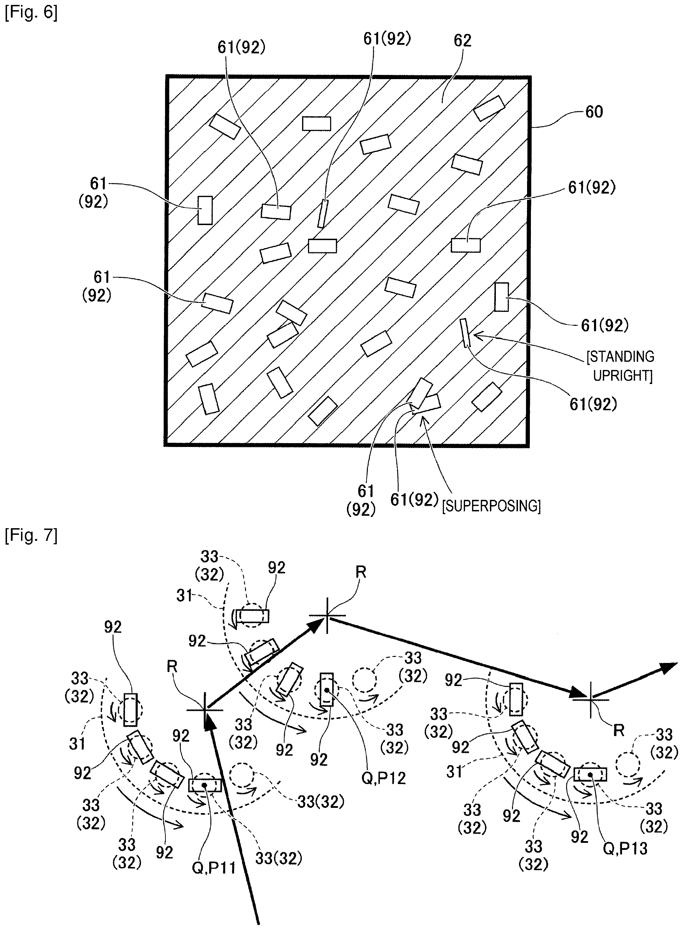

Specifically, as illustrated in Figs. 4 and 6, when components 92 are so close to contact each other or are superposed one on the other (in a vertically overlapping state), or components 92 are oriented upright in such a manner that a width direction constitutes a vertical direction in supply area As, those components 92 cannot constitute a pickup target. In addition, since components 92 are supplied to supply area As while being oriented irregularly, component mounter 10 executes recognition processing of a supply state (whether components 92 can be picked up, and how components 92 which can be picked up are oriented).

Bulk feeder 50 includes feeder main body 51 having a flat box shape. When bulk feeder 50 is set in slot 121 of component supply device 12, bulk feeder 50 is electrically fed and is then put in a state in which bulk feeder 50 can communicate with control device 20. Bulk feeder 50 includes track member 56 provided at a front upper portion of feeder main body 51. Track member 56 is formed so as to extend in a front-rear direction of feeder main body 51 (a left-right direction in Fig. 4). Pair of side walls 561, protruding upwards, are formed on both edges of track member 56 in a width direction thereof (in a vertical direction in Fig. 4). Pair of side walls 561 surround a periphery of a conveyance path together with a distal end portion 562 of track member 56 to thereby prevent the departure of components 92 which are being conveyed along the conveyance path from the conveyance path.

Supply area As is formed on track member 56 which is configured as described above. This "supply area As" is an area where components 92 are supplied in a bulk state. In other words, supply area As constitutes an area where components 92 can be picked up by suction nozzles 33 supported on mounting head 30 and is included in a movable range of mounting head 30. In addition, "conveyance path" of track member 56 is a path of components 92 from an area where components 92 are supplied from a component case, not shown, to supply area As.

With bulk feeder 50 configured as described above, vibrations are applied to track member 56 by a vibration device, which is not illustrated, so as to apply forward or rearward and vertical external forces to components 92 on the conveyance path. As a result, bulk feeder 50 can convey multiple components 92 discharged from the component case onto track member 56 to supply area As by way of the conveyance path. The supply process of components 92 described above is executed as required by a feeder control section, not illustrated, in response to a command from an external section.

### 1-3. Component Transfer Device 13

Component mounter 10 includes component transfer device 13. Component transfer device 13 transfers components supplied by component supply device 12 to predetermined mounting positions on board 91. Component transfer device 13 includes head driving device 131, moving platform 132, and mounting head 30. Head driving device 131 moves moving platform 132 in horizontal directions (X-direction and Y-direction) using a linear motion mechanism. Mounting head 30 is detachably fixed to moving platform 132 by a clamp member, not illustrated, and is provided so as to be movable in the horizontal directions within component mounter 10.

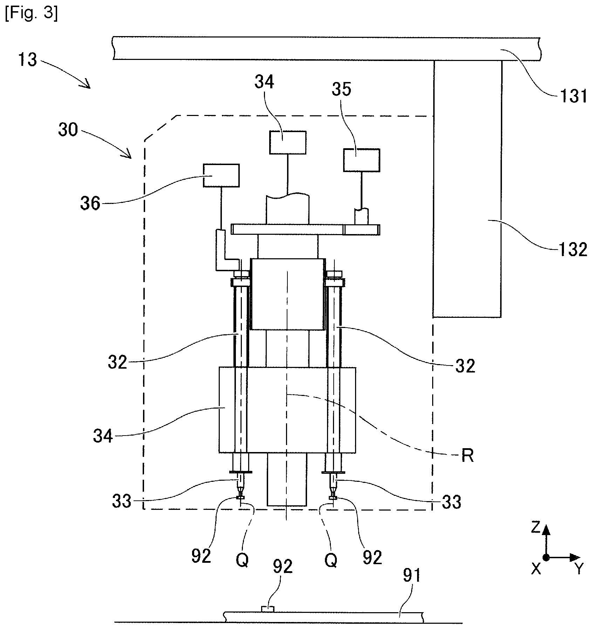

As illustrated in Figs. 2 and 3, mounting head 30 has rotary head 31, which is provided so as to rotate about an R-axis which is parallel to a vertical axis (a Z-axis). Rotary head 31 supports multiple holders 32 in such a manner that multiple holders 32 can be lifted up and lowered and that multiple holders 32 can rotate individually and separately about their corresponding rotation axes (Q-axes). Multiple holders 32 each have a holding member attached thereto to hold component 92. In the present embodiment, the holding member is suction nozzle 33 configured to hold component 92 by picking up relevant component 92 through suction using negative pressure air supplied thereto. A chuck or the like configured to hold a component by gripping the component can be adopted as the holding member.

Mounting head 30 includes R-axis rotation device 34 configured to rotate rotary head 31 about the R-axis. R-axis rotation device 34 angularly positions rotary head 31 at a predetermined angle about the R-axis to thereby index one holder 32 to a lifting and lowering position where that one holder 32 is lifted up and lowered by lifting and lowering device 36, which will be described later on. Mounting head 30 includes Q-axis rotation device 35 configured to rotate holder 32 about the Q-axis thereof. In the present embodiment, Q-axis rotation device 35 has a mechanism for rotating multiple holders 32 in an interlocked fashion and is used commonly to rotate multiple holders 32. With the configuration described above, when one holder 32 is angularly positioned at a predetermined angle about the Q-axis thereof, remaining multiple holders 32 are also angularly positioned to the predetermined angle in the interlocked fashion with the angular positioning of the one holder 32.

Mounting head 30 has lifting and lowering device 36 configured to lift up and lower one holder 32 in multiple holders 32 which is indexed to the lifting and lowering position by the rotation of rotary head 31. Lifting and lowering device 36 lifts up and lowers holder 32 to thereby lift up and lower suction nozzle 33 attached to relevant holder 32. Mounting head 30 can adopt a configuration in which mounting head 30 has multiple lifting and lowering devices which can be driven independently so as to independently lift up and lower holders 32 which are positioned individually in two or more lifting and lowering positions so provided.

The number of holders 32 supported by mounting head 30 configured as described above can differ in accordance with types of mounting heads 30. In addition, mounting head 30 can adopt various aspects in addition to an aspect like one of the present embodiment in which multiple holders 32 are supported into a ring-like configuration at equal intervals. For example, mounting head 30 may adopt an aspect in which mounting head 30 supports multiple holders 32 which are arranged into a straight line or a matrix configuration.

### 1-4. Part Camera 14 and Board Camera 15

Component mounter 10 includes part camera 14 and board camera 15. Part camera 14 and board camera 15 are digital imaging devices having an imaging element, such as CMOS. Part camera 14 and board camera 15 execute imaging based on a control signal and transmit image data acquired by the imaging. Part camera 14 is configured to be able to image a component held by suction nozzle 33 from below. Board camera 15 is provided on moving platform 132 so as to move in the horizontal directions together with mounting head 30. Board camera 15 is configured to image board 91 from above.

Board camera 15 can image a front surface of board 91 as an imaging target and can also image various types of devices additionally as imaging targets as long as those devices fall within the movable range of moving platform 132. For example, in the present embodiment, as illustrated in Fig. 4, board camera 15 can image supply area As to which bulk feeder 50 supplies components 92 by capturing relevant supply area As within visual field Vc thereof. Thus, as described above, board camera 15 can be used commonly to image different imaging targets in order to acquire image data for use in various image processings.

### 2. Control device 20

As illustrated in Fig. 1, component mounter 10 includes control device 20. Control device 20 is made up mainly of CPU, various types of memories, and a control circuit. Control device 20 includes storage section 21 as illustrated in Fig. 5. Storage section 21 is made up of an optical drive device such as a hard disk device or a flash memory. Various types of data such as control program M1 used for controlling a mounting process and the like are stored in storage section 21 of control device 20. Control program M1 indicates mounting positions, mounting angles, and a mounting order of component 92 to be mounted on board 91 in a mounting process (refer to Fig. 7).

### 2-1. Mounting Control Section 22

As illustrated in Fig. 5, control device 20 includes mounting control section 22. Mounting control section 22 controls operations of component transfer device 13 and the like, and executes a mounting process of mounting components 92 on board 91. In the mounting process mentioned above, mounting control section 22 executes a PP cycle (pick-and-place cycle) including a pickup operation of picking up component 92 supplied by component supply device 12 with the holding member (suction nozzle 33) and a mounting operation of mounting component 92 so picked up in a predetermined mounting position at a predetermined angle on board 91.

The "pickup operation" described above includes an operation of picking up component 92 from supply area As where multiple components 92 are supplied in a bulk state. In the present embodiment, in execution of the pickup operation described above, mounting control section 22 causes mounting head 30 to operate so as to pick up components 92 which are set as pickup targets by setting section 24, which will be described later, in a predetermined pickup order.

Mounting control section 22 executes recognition processing of recognizing a holding state of each of components 92 held by the multiple holding members (suction nozzles 33). Specifically speaking, mounting control section 22 executes image processing on image data acquired through imaging of part camera 14 to thereby recognize the position and angle of each component 92 with respect to a reference position of mounting head 30. Mounting control section 22 may be configured to execute image processing on image data acquired by imaging component 92 from a side, below, or above using a head camera unit provided integrally on mounting head 30 in place of part camera 14.

In the mounting process in the PP cycle, mounting control section 22 executes a mounting movement and a mounting rotation based on control program M1. The "mounting movement" mentioned above is a moving operation of moving mounting head 30 so as to move the holding member (suction nozzle 33) from a current position to a mounting position defined in the mounting operation. Additionally, the "mounting rotation" is an operation of rotating holder 32 so as to angularly position component 92 held by the holding member (suction nozzle 33) at a mounting angle defined in the mounting operation. As a result, the position and angle of component 92 held by each of multiple suction nozzles 33 are controlled.

### 2-2. State Recognition Section 23

As illustrated in Fig. 5, control device 20 includes state recognition section 23. State recognition section 23 executes recognition processing of recognizing a supply state of components 92 in supply area As of bulk feeder 50. The "supply state recognition processing" mentioned above includes recognition processing of recognizing whether there exists component 92 which can be picked up in supply area As and recognizing, when there exists component 92 which can be picked up therein, a position and angle of relevant components 92.

In the present embodiment, state recognition section 23 executes the recognition processing of a supply state described above using post-processing image data 60 in which predetermined image processing is executed on image data 60 acquired through imaging by board camera 15. As the "predetermined image processing" mentioned above, binarization processing is adopted which uses a threshold set at a value between a brightness of component area 61 including a main body portion and a terminal of component 92 and a brightness of background 62.

When the image processing described above is executed, as illustrated in Fig. 6, component area 61 becomes white, while background 62 becomes black. In Fig. 6, as a matter of convenience, an area in black or of a color close to black is illustrated as hatched. An upper surface of track member 56 making up supply area As serving as background 62 of image data 60 is colored in a color closer to black than any portion of component 92.

State recognition section 23 recognizes that a white area constitutes component area 61 based, for example, on a surface area of the white area in image data 60. For this recognition, state recognition section 23 may calculate a surface area of component area 61 based on the number of pixels forming component area 61 in image data 60. Then, state recognition section 23 recognizes a position and angle of component 92 based on a shape and angle of component area 61 so recognized. As a result, state recognition section 23 recognizes a supply state of component 92 in supply area As.

For specification of a shape of component area 61, state recognition section 23 may specify a shape of component area 61 based, for example, on a shape of a rectangular frame of a minimum surface area which circumscribes component area 61. State recognition section 23 may define the shape of the rectangular frame itself as the shape of component area 61 or a shape resulting from offsetting constituent sides of the rectangular frame inwards by a predetermined amount as the shape of component area 61.

The supply state in supply area As recognized by state recognition section 23 includes any one of a component orientation which indicates whether a thickness direction of component 92 constitutes a vertical direction thereof, a degree of separation which indicates whether multiple components 92 are closer to one another than a predetermined distance, and a pickup possibility which indicates whether components 92 can be picked up from supply area As. The component orientation as the supply state may include a position and angle of component 92 with respect to the reference position of bulk feeder 50 in addition to an orientation of component 92 which differs depending on which surface of component 92 is in contact with track member 56.

The degree of separation as the supply state indicates an extent to which one component 92 is separated from other components 92 and decreases as the one component 92 comes closer to the other components 92. The degree of separation may be defined as acceptable, for example, if no other component 92 exists within a range which is defined as spreading radially a predetermined distance from one component 92, while the degree of separation may be defined as unacceptable if even a part of another component 92 exists within the predetermined-distance range. For example, the degree of separation becomes lower than a reference value when two or more components 92 are superposed one on the other or another or are in contact with each other or one another in a horizontal direction.

The pickup possibility as the supply state indicates whether individual components 92 supplied in supply area As are suitable for a pickup operation target. The pickup possibility may be determined based on the component orientation or the degree of separation described above, or may be determined as required based on types of components 92, types of suction nozzles 33 to be used, precision required for a mounting process, or the like.

### 2-3. Setting Section 24

As illustrated in Fig. 5, control device 20 includes setting section 24. Setting section 24 sets component 92 to be a pickup target in multiple components 92 supplied to supply area As based on the supply state thereof recognized by state recognition section 23. More specifically, in the case that a PP cycle includes a pickup operation which is operated multiple times to pick up components 92 of the same type, setting section 24 sets a required number of components 92 to be picked up (the number of components 92 to be used in one PP cycle) from supply area As.

For this setting, setting section 24 sets components 92 to be a pickup target in multiple components 92 which are supplied to supply area As in an appropriate orientation (for example, in the case of component 92 needing to be distinguished between front and back, an orientation in which component 92 is oriented so that a front surface constitutes an upper surface) and a pickup order so that an overall required time of the pickup operation which is executed multiple times in principle is shortened. In the present embodiment, in addition to the supply state recognized by state recognition section 23, setting section 24 sets components 92 to be a pickup target and a pickup order based on a mounting angle for each of multiple mounting operations executed in the PP cycle.

### 3. Details of Setting Processing by Setting Section 24 and Mounting Process

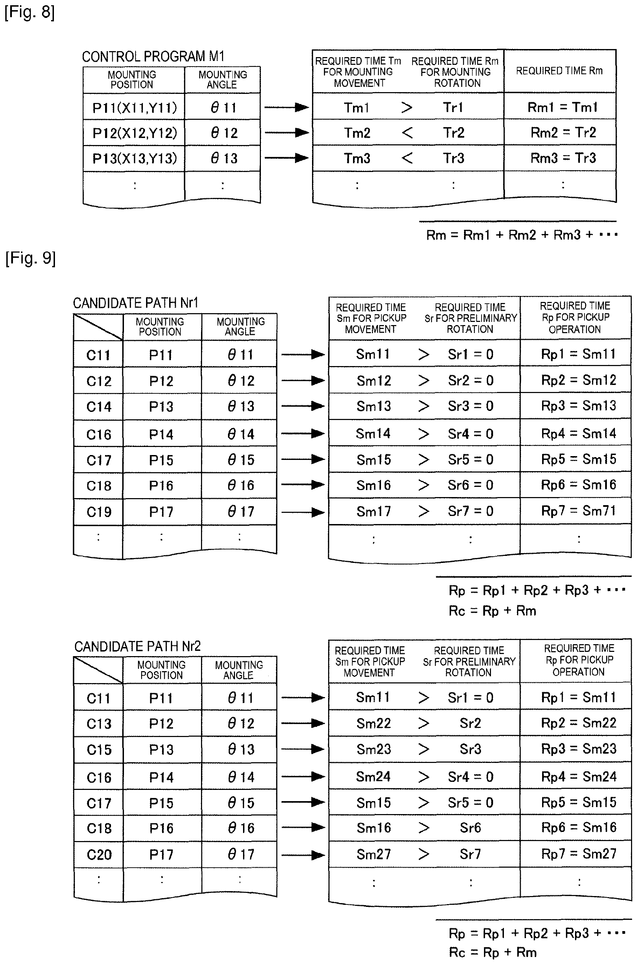

Referring to Figs. 7 to 12, details of the setting processing of setting components 92 to be a pickup target and a pickup order by setting section 24 and a mounting process including the setting processing will be described. Here, as illustrated in Figs. 7 and 8, components 92 picked up through multiple pickup operations are moved to corresponding predetermined mounting positions (P11, P12, P13, ...) by mounting head 30 which moves accordingly, and are then mounted on board 91 as a result of the holders being lowered accordingly. For these mounting operations, those components 92 picked up and held by the holders are rotated to corresponding predetermined mounting angles (θ 11, θ 12, θ 13, ...) for mounting while being moved to the corresponding predetermined mounting positions as described above.

Then, a required time (Rm1, Rm2, ...) for one mounting operation is either a required time (Tm1, Tm2, ...) for a mounting movement associated with the mounting operation or a required time (Tr1, Tr2, ...) for a mounting rotation associated with the mounting operation which is longer. That is, in the case that a required time (Tr2) for a second mounting rotation is longer than a required time (Tm2) for a second mounting movement corresponding to a distance from the current position (for example, a position corresponding to the present mounting position) to a subsequent position (Tm2<Tr2), as illustrated in Fig. 8, a required time (Rm2) for a second mounting operation is the required time (Tr2) for the second mounting rotation (Rm2=Tr2). As this occurs, while the mounting operation is being executed, when holder 32 arrives at a position lying above a mounting position, relevant holder 32 is held staying in that state, and additionally, relevant holder 32 has to wait for a rotation about its Q-axis in that state.

To describe this accurately, the mounting operation includes a lifting and lowering operation of holder 32 and suction nozzle 33, and in parallel with a part of this lifting and lowering operation, the mounting movement and the mounting rotation can be executed. However, with the lifting and lowering operation, a degree at which a required time (Rm1, Rm2, . . ) for each aspect of a mounting operation is affected is relatively small when compared with the mounting movement or mounting rotation. As a result, in the present embodiment, as a matter of convenience, the required time for the lifting and lowering operation is omitted from consideration when the required time (Rm1, Rm2, ..) for the mounting operation is described.

As described above, when holder 32 is caused to wait for rotation in the PP cycle, there is caused a concern that the required time (Rm1, Rm2, ..) for the mounting operation is extended. Then, in the present embodiment, as described above, when picking up multiple components 92 from supply area As where multiple components 92 are supplied in a bulk state, a configuration is adopted in which components 92 to be a pickup target and a pickup order are set by considering in advance a mounting angle for each mounting operation as well as pickup possibility. This enables components 92 to be picked up in orientations suitable for the mounting operation. As a result, the pickup operation and the mounting operation can be made efficient, thereby making it possible to shorten required time Rc for the PP cycle.

Here, in the case that setting section 24 sets components 92 to be a pickup target and the pickup order based on the mounting angles, mounting control section 22 executes a pickup movement and a preliminary rotation in a pickup operation in the PP cycle. The "pickup movement" mentioned above means an operation of moving mounting head 30 so as to move the holding member (suction nozzle 33) from the current position (for example, a position corresponding to the present pickup position) to one of multiple components 92 in supply area As. The "preliminary rotation" mentioned above is an operation of rotating holder 32 preliminarily in accordance with a mounting angle of a mounting operation for mounting component 92 picked up through the pickup operation onto board 91.

In the present embodiment, a rotation amount of holder 32 in the preliminary rotation is calculated for each pickup operation by setting section 24. In addition, since no preliminary rotation is necessary in the case that the rotation amount is 0, the rotation amount described above substantially indicates whether the preliminary rotation is necessary. When executing the pickup operation multiple times, mounting control section 22 causes components 92 to be picked up sequentially according to components 92 to be a pickup target and the pickup order which are set by setting section 24 and further by preliminarily rotating holders 32 by designated rotation amounts.

Here, as shown in an upper portion of Fig. 9, a required time (Rp1, Rp2, ...) for one pickup operation is either a required time (Sm11, Sm12, ...) for a pickup movement associated with the pickup operation or a required time (Sr1, Sr2, ...) for a preliminary rotation associated with the pickup operation which is longer. In the present embodiment, setting section 24 adopts an aspect in which the fact that the required time (Sr1, Sr2, ...) for the preliminary rotation is equal to or smaller than the required time (Sm11, Sm12, ...) for the pickup movement constitutes one of conditions under which a preliminary rotation is executed in the pickup operation. According to this aspect, regardless of whether a preliminary rotation is executed in the pickup operation, as shown in the upper portion of Fig. 9, the required time (Rp1, Rp2, ...) for the pickup operation is the required time (Sm11, Sm12, ...) for the pickup movement (Rp1=Sm11, Rp2=Sm12, ...).

To describe this accurately, the pickup operation includes the lifting and lowering operation of holder 32 and suction nozzle 33, and the pickup movement and the preliminary rotation are executed in parallel with a part of the lifting and lowering operation. For the same reason as the reason described in relation to the lifting and lowering operation in the mounting operation, in the present embodiment, as a matter of convenience, the required time for the lifting and lowering operation is omitted from consideration when the required time Rm1 for the pickup operation is described.

Then, required time Rc for the PP cycle is the sum of the required times for all the pickup operations and the mounting operations included in the PP cycle (Rc=Rp+Rm). The required time (Rp) for the pickup operation is the sum of the required times for all the pickup operations in one PP cycle (Rp=Rp1+Rp2+Rp3+ . . .). Similarly, the required time (Rm) for the mounting operation is the sum of the required times for all the mounting operations in one PP cycle (Rm=Rm1+Rm2+Rm3+...).

In addition, when executing a pickup operation including a preliminary rotation, mounting control section 22 rotates holder 32 by a designated rotation amount. As a result, in a normal case, although a trial pickup is attempted in which component 92 is placed at a predetermined angle (for example, an angle of 0 degree) with respect to a reference angle about the Q-axis of holder 32 or suction nozzle 33, with the present embodiment, component 92 is picked up at an angle corresponding to the rotation amount of the preliminary rotation with respect to the reference angle and the orientation (supply angle) of component 92.

Specifically speaking, for example, when the mounting angle is 90 degrees, and the supply angle of component 92 is 20 degrees, setting section 24 sets the rotation amount of the preliminary rotation at 70 degrees. Then, mounting control section 22 causes suction nozzle 33 to pick up component 92 which is oriented to be inclined at 20 degrees in such a state that holder 32 is preliminarily rotated by 70 degrees. As a result, component 92 is picked up in such a state that component 92 is rotated through 90 degrees about the Q-axis with respect to the reference angle of holder 32 or suction nozzle 33.

Then, when executing the mounting operation, mounting control section 22 omits the mounting rotation or decreases the rotation amount of holder 32 in the mounting rotation in accordance with the rotation amount of holder 32 in the preliminary rotation executed previously. That is, with the case described above, although the mounting rotation of 90 degrees has to be executed in parallel with the mounting movement in the mounting operation, since component 92 has already been rotated with respect to the reference angle in the pickup operation, the mounting rotation can be omitted. To describe this accurately, mounting control section 22 can execute the mounting rotation by such an extent corresponding to a correction amount based on the results of the recognition processing of the holding state of component 92 by suction nozzle 33.

As a result, for example, in a mounting operation in which waiting for rotation normally occurs, since the required time for mounting rotation can be eliminated or reduced, as a result, the required time for the mounting operation can be shortened. However, when priority is given to suppression of occurrence of such rotation waiting, in order to pick up component 92 which is oriented suitable for the mounting angle in the mounting operation, for example, component 92 having a long pickup moving distance is selected as a pickup target. Then, the required time for the pickup movement is extended, thereby causing a possibility that the required time (Rc) for the PP cycle is extended more.

Then, in the present embodiment, setting section 24 sets a step of seeing whether to execute a preliminary rotation for each of multiple pickup operations to be executed based on the required time (Rc) for the PP cycle. Specifically speaking, when setting components 92 to be a pickup target in multiple components 92 supplied to supply area As and a pickup order, setting section 24 first searches for candidates for a path for picking up components 92. Then, setting section 24 evaluates the candidates based on various conditions and selects an appropriate candidate.

In addition, when searching for candidates for a component pickup path, setting section 24 can adopt a known method for extracting a required number of components 92 (for example, the number of suction nozzles 33=12) from multiple components 92 that can picked up, which is included in the results of the recognition processing of the supply state. For example, setting section 24 can adopt appropriately a branch and bound method or a cutting plane method which is known as a solution method for solving a traveling salesman problem (TSP).

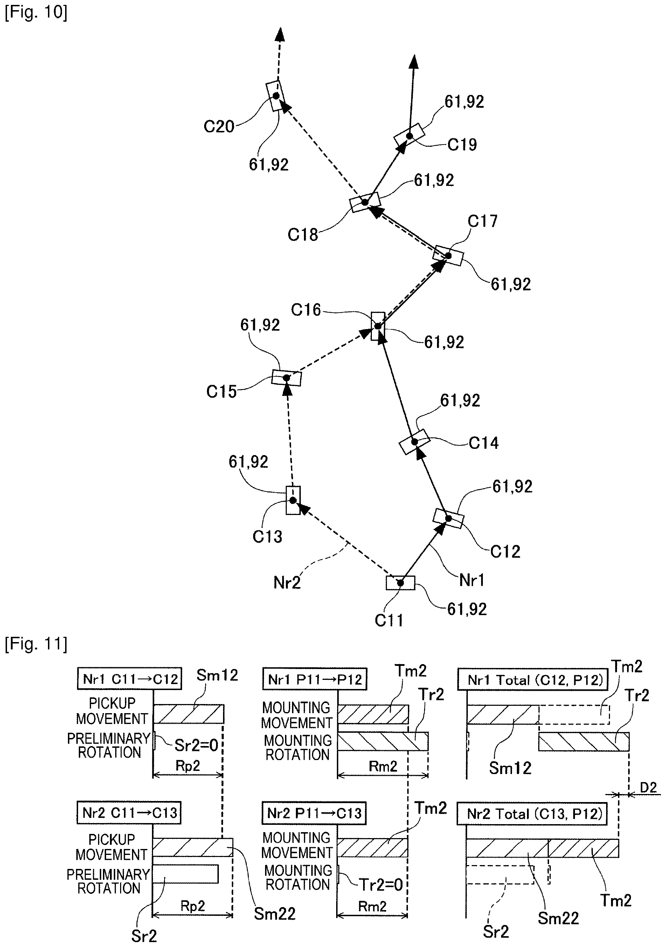

Here, as illustrated in Fig. 10, it is assumed that first candidate Nr1 and second candidate Nr2, which denote two types of paths, are detected as a result of searching processing by setting section 24. First candidate Nr1 is a path which passes through supply positions of multiple components 92 in an order along arrows indicated by a solid line (C11, C12, C14, C16, C17, C18, C19, ...). Second candidate Nr2 is a path which passes through supply positions of multiple components 92 in an order along arrows indicated by a broken line (C11, C13, C15, C16, C17, C18, C20, ...).

Let's assume that multiple components 92 picked up in the order described above are mounted in multiple mounting positions (P11, P12, P13, . . .) illustrated in Figs. 7 and 8. Here, as illustrated in Fig. 11, an explanation will be made by paying attention to a pickup operation and a mounting operation for second component 92 in each of the candidates. That is, first candidate Nr1 shows a pickup operation for supply position C12, while second candidate Nr2 shows a pickup operation for supply position C13. Although a mounting operation onto mounting position P12 is common, the first and second candidates have different rotation amounts in respective mounting rotations.

First candidate Nr1 is set so that component 92 in second supply position C12 is picked up without any preliminary rotation. As a result, with first candidate Nr1, priority is given to shortening a movement distance and a required time (Sm12) of a pickup movement. On the other hand, with a mounting operation to which first candidate Nr1 is applied, a required time (Tm2) for a mounting movement becomes longer than a required time (Tr2) for a mounting rotation, thereby causing rotation waiting to occur. As a result, the required time for the pickup operation and the mounting operation associated with second component 92 is the sum of the required time (Tm2) for the pickup movement and the required time (Tr2) for the mounting rotation.

Second candidate Nr2 is set so that component 92 in second supply position C13 is picked up while being rotated preliminarily. As a result, with second candidate Nr2, priority is given to picking up component 92 in such a state that holder 32 is rotated in advance. Due to this, with second candidate Nr2, a required time (Rp2) for a pickup operation becomes longer than that of first candidate Nr1. On the other hand, with a mounting operation to which second candidate Nr2 is applied, a required time (Tm2) for a mounting movement is shorter than a required time (Tr2=0) for a mounting rotation, thereby causing no rotation waiting to occur. As a result, with second candidate Nr2, a required time (Rm2) for a mounting operation is shorter than that of first candidate Nr1.

With the example described above, the required time for the pickup operation and the mounting operation associated with second component 92 becomes shorter with second candidate Nr2 (Sm22+Tm2) than with first candidate Nr1 (Sm12+Tr2) by difference D2. However, since distances of the current and subsequent pickup movements become longer as the component in second supply position C13 set in second candidate Nr2 stays farther from supply positions C11, C15 of other components 92, there may also be a case in which the required time can be shortened more when component 92 in supply position C12 is picked up without any preliminary rotation on the contrary.

Further, although attention is paid to the pickup operation and the mounting operation of second component 92 here to simplify the description, positions of third and latter components 92 can change depending on the position of second component 92. Then, for example, there is a case in which components 92 which can be picked up or components 92 which are suitable for the mounting angles gather in a predetermined range, and in that case, it is also assumed efficient to set preferentially those components 92 included in the predetermined range as a pickup target.

Then, setting section 24 desirably executes searching processing of searching for path candidates, calculates PP cycle required times (Rc) for multiple candidates detected, and uses a path candidate having a shorter required time (Rc). However, setting section 24 need execute the path candidate searching processing described above within a limited time period during execution of a mounting process. To make this happen, in the present embodiment, setting section 24 controls the priorities of the path candidates based on preset conditions.

Specifically speaking, when setting components 92 to be a pickup target in multiple components 92 supplied to supply area As and a pickup order, in the case that there are multiple path candidates Nr for picking up components 92, setting section 24 may increase the priority of adoption for a path candidate whose path is more linear. When increasing the priority, setting section 24 may increase further the priority for a path candidate in which a coordinate value in the X-direction or the Y-direction of mounting head 30 monotonously increases or monotonically decreases. This can reduce the influence of mechanical operation errors such as backlash.

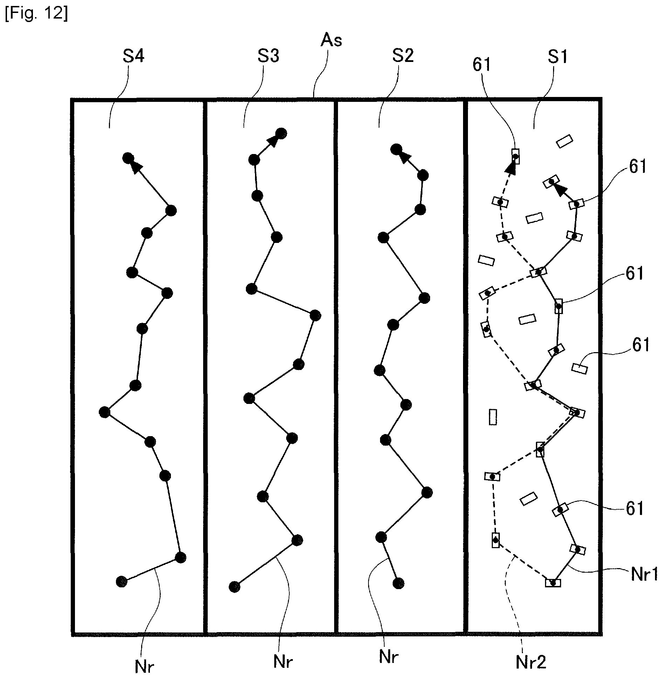

Incidentally, components 92 which can be picked up may be supplied to supply area As more than a required number for one PP cycle. This may change depending on a required number, dimensions of components 92, the surface area of supply area As, and the like. For example, there may be a case in which a number of components 92 required for four PP cycles are supplied to supply area As in such a state that those components 92 can be picked up immediately after bulk feeder 50 has executed a supply process of components 92. Assuming the aspect described above, supply area As may be virtually divided into multiple partitions S1 to S4 as illustrated in Fig. 12.

Then, state recognition section 23 executes processing for recognizing a supply state for each of multiple partitions S1 to S4 in supply area As. Similarly, setting section 24 sets components 92 to be a pickup target in multiple components 92 supplied to a partition in multiple partitions S1 to S4 in supply area As for which a supply state is recognized and a pickup order. Further, setting section 24 sets pickup orders of components 92 which are to be used for a subsequent and latter PP cycles for the remaining partitions of the multiple partitions in parallel with a PP cycle which is being executed.

That is, setting section 24 does not execute the searching processing to detect many path candidates over the whole area of supply area As but executes the searching processing for searching for path candidates only for a part (one partition) of supply area As. Then, setting section 24 sets a path candidate suitable for a PP cycle to be executed currently for one partition. As a result, a rotation amount of a preliminary rotation is set in addition to components 92 to be a pickup target and the pickup order. Mounting control section 22 executes the current PP cycle after the pickup order of components 92 and the like have been set completely.

After having set the path candidate for one partition, setting section 24 executes the path candidate searching processing for at least one of the remaining partitions to thereby set a path candidate suitable for a subsequent PP cycle in parallel with execution of the current PP cycle. This can distribute the load of the path candidate searching processing and the load of evaluation processing for setting respective priorities of the path candidates so detected.

In the case that no preliminary rotation is executed, mounting control section 22 can execute a pickup rotation for matching the reference angle of holder 32 or suction nozzle 33 with a supply angle of component 92 in a pickup operation. For example, with a mounting angle of 90 degrees and a supply angle of component 92 of 20 degrees, mounting control section 22 executes a pickup rotation for picking up component 92 in such a state that holder 32 is rotated by - 20 degrees or 20 degrees reversely so that component 92 is picked up at an angle of 0 degree with respect to the reference angle.

Mounting control section 22 may switch the pickup rotation between execution and non-execution in the mounting operation described above or may set so that the pickup rotation is not executed normally. Then, in a control aspect in which the pickup rotation is executed in the case that no preliminary rotation is executed, setting section 24 may set so that the preliminary rotation is to be executed or not to be executed based on the required time for the pickup movement, the required time of the preliminary rotation, and the required time for the pickup rotation.

### 4. Mounting Process by Component Mounter 10

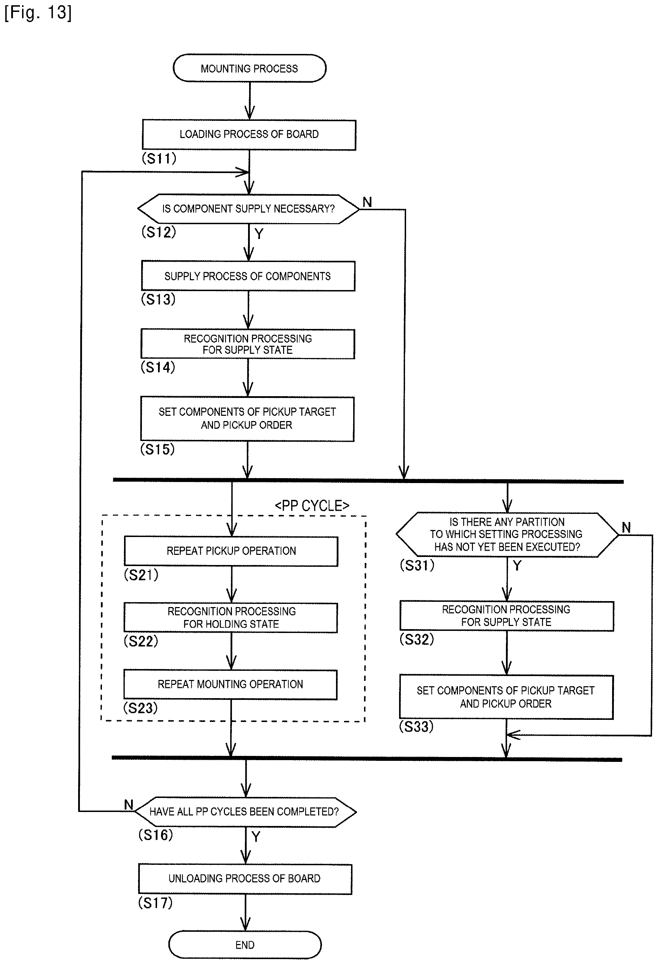

Referring to Fig. 13, a mounting process by component mounter 10 will be described. First, as illustrated in Fig. 13, board conveyance device 11 executes a conveyance process of conveying in board 91 (S11). As a result, board 91 is conveyed into component mounter 10 and is then position in a predetermined position therein. Next, if a component supply is required as when there is a shortage of components 92 in supply area As (S12 : Yes), control device 20 sends a command to bulk feeder 50 to execute a supply process of components 92.

Bulk feeder 50 executes a supply process in response to the command from control device 20 (S13). As a result, multiple components 92 are supplied to supply area As. In addition, the execution of the supply process cancels the result of the recognition processing of the supply state executed previously by state recognition section 23. Subsequently, state recognition section 23 executes recognition processing of a supply state for one partition of multiple partitions S1 to S4 (S14).

Setting section 24 sets components 92 to be a pickup target in multiple components 92 supplied to the one partition and a pickup order (S15). Thereafter, for example, if the supply process is determined unnecessary since a required number of components 92 for a subsequent PP cycle can be picked up in supply area As in S12 (S12 : No), mounting control section 22 executes the PP cycle.

Mounting control section 22 executes the pickup operation multiple times repeatedly for components 92 set to be a pickup target in accordance with the pickup order set by setting section 24 in the PP cycle (S21). At this time, mounting control section 22 executes a necessary preliminary rotation in accordance with the set rotation amount in the pickup operation. Subsequently, state recognition section 23 executes recognition processing for a holding state of a component held by each of multiple suction nozzles 33 (S22).

Mounting control section 22 executes the mounting operation multiple times repeatedly based on the results of the recognition processing (S22) (S23). In the mounting operation, mounting control section 22 executes the mounting movements and the mounting rotations so that components 92 are mounted in the predetermined mounting positions at the predetermined mounting angles which are designated by control program M1. For execution of the mounting rotation, if the preliminary rotation has been executed in S21, the rotation amount of the mounting rotation in the corresponding mounting operation is set to 0 or reduced.

Setting section 24 executes the setting processing for setting components 92 to be a pickup target and a pickup order as required in parallel with the PP cycle (S21 to S23) described above. Specifically speaking, if there remains a partition or partitions in multiple partitions S1 to S4 for which the setting processing has not yet been executed (S31: Yes), firstly, state recognition section 23 executes the recognition processing for a supply state on at least one of the remaining partitions (S32). Then, setting section 24 executes the searching processing for a path candidate on the partitions for which the supply state is recognized and sets a path candidate suitable for a subsequent PP cycle (S33).

Mounting control section 22 determines whether all the PP cycles have been completed based on control program M1 (S16). If all the PP cycles have not yet been completed (S16: No), mounting control section 22 executes the PP cycle (S21 to S23) repeatedly from the determination on whether the supply process of components 92 is necessary (S12). If all the PP cycles have been completed (S16 : Yes), control device 20 executes an unloading process of board 91 (S17). In the unloading process of board 91, board conveyance device 11 unclamps board 91 which is positioned and then conveys board 91 out of component mounter 10.

### 5. Modified Aspect of Embodiment

### 5-1. Mounting Head 30

In the present embodiment, mounting head 30 is configured to have the Q-axis rotation device 35 for rotating multiple holders 32 in the interlocked fashion. In contrast with this, mounting head 30 may be configured to have multiple rotation devices for rotating multiple holders 32 about their own Q-axes independently of one another. However, from the viewpoint of downsizing and cost reduction of mounting head 30, the aspect exemplified in the present embodiment is preferable.

### 5-2. Setting Process

In the present embodiment, in the setting processing for setting components 92 to be a pickup target and a pickup order by setting section 24, a path candidate to be adopted is configured to be set based on the required time (Rc) of the PP cycle. As a method of shortening the required time (Rc) of the PP cycle, it is useful to control the priorities of path candidates to be adopted in accordance with the configuration of component mounter 10, types of board products, and the like.

For example, in a mechanical configuration in which component mounter 10 includes multiple mounting heads 30, which are configured to execute alternately a mounting operation on identical board 91, since respective movable ranges of multiple mounting heads 30 overlap each other or one another, priority is given to shortening required times for the mounting processes in a PP cycle. In such a case, even though a required time for a pickup operation in the PP cycle has to become long to some extent, it is useful to execute a preliminary rotation so as to shorten a required time for a subsequent mounting operation.

In addition, depending on types of board products, types of components 92 to be used many differ, and a required mounting accuracy also differs. As a result, for example, the success rate of the pickup operation or the mounting operation, as well as the execution frequency of recovery processing for errors can change. In such a case, it is assumed that a path having a certain degree of redundancy (for example, a path suitable for interruption by the recovery processing) is actually more useful than an ideal path for minimizing the required time for the PP cycle.

In consideration of the circumstances described above, setting section 24 receives setting of evaluation parameters for multiple path candidates including the partitions of supply area As. Then, in the case that multiple path candidates are detected, setting section 24 calculates a priority for each of the multiple path candidates based on the set evaluation parameters and sets a path candidate having a high priority to be suitable for the PP cycle.

### 5-3. Cameras

In the present embodiment, the configuration is adopted in which board camera 15 functions as a camera for imaging supply area As of bulk feeder 50. In contrast with this, component mounter 10 may include a camera provided above bulk feeder 50 so as to image supply area As thereof. The camera may be dedicated to imaging of supply area As or may be shared for other applications.

With this configuration, since the camera is fixed and can image supply area As at an arbitrary timing, the recognition processing for a supply state and the setting processing by setting section 24 can be executed regardless of the position of mounting head 30. However, the aspect exemplified in the present embodiment is preferable from the viewpoint of reducing the facility cost.

### Reference Signs List

10: component mounter, 12: component supply device, 15: board camera, 20: control device, 21: storage section, 22: mounting control section, 23: state recognition section, 24: setting section, 30: mounting head, 31: rotary head, 32: holder, 33: suction nozzle (holding member), 34: R-axis rotation device, 35: Q-axis rotation device, 36: lifting and lowering device, 50: bulk feeder, 91: board, 92: component, As: supply area, S1-S4: partition.

## Claims

1. A component mounter (10) comprising:
a mounting control section (22) configured to execute a pick-and-place cycle including a pickup operation for picking up a component (92) from a supply area (As) and a mounting operation for mounting the component (92) in a predetermined mounting position at a predetermined mounting angle on a board (91);
a state recognition section (23) configured to recognize a supply state including positions of a multiplicity of the components (92);
a setting section (24) configured to set the components (92) to be a pickup target in the multiplicity of the components (92) supplied to the supply area (As) and a pickup order based on the positions so recognized and the mounting angle for each mounting operation which is executed multiple times in the pick-and-place cycle; and
a mounting head (30) configured to move in a horizontal direction within the component mounter (10),
wherein the mounting head (30) is configured to support multiple holders (32) to which holding members (33) for holding the components (92) are attached individually in such a manner as to allow the multiple holders (32) not only to be lifted up and lowered but also to rotate individually about their own rotation axes,
wherein the mounting control section (22) is configured
to execute a mounting movement for moving the mounting head (30) so as to move the holding member (33) from a current position to the mounting position in the mounting operation and a mounting rotation for rotating the holder (32) so as to take the mounting angle in the mounting operation of the pick-and-place cycle,
to execute a pickup movement for moving the mounting head (30) so as to move the holding member (33) from a current position to one of the multiplicity of the components (92) in the supply area (As) and a preliminary rotation for rotating in advance the holder (32) in accordance with the mounting angle in the mounting operation at which the component (92) picked up in the pickup operation is mounted on the board (19) in the pickup operation of the pick-and-place cycle, and
to omit the mounting rotation or reduce a rotation amount of the holder (32) in the mounting rotation in accordance with a rotation amount of the holder (32) in the preliminary rotation,
**characterized in that**
the multiplicity of components (92) is supplied in a bulk state to the supply area (As),
the supply state recognized by the state recognition section (23) includes not only positions but also orientations of the multiplicity of components (92) that is supplied,
the setting section (24) is further configured to set the components (92) to be a pickup target and the pickup order not only based on the positions but also based on the orientations included in the recognized supply state,
the pickup order is set by considering in advance a mounting angle for each mounting operation as well as a pickup possibility so that a required time (Rc) for the pick-and-place cycle is shortened,
wherein the required time (Rc) for the pick-and-place cycle is the sum of the required times for all the pickup operations and the mounting operations included in the pick-and-place cycle, and
the mounting control section (22) is further configured to take into account the orientation included in the supply state when executing the preliminary rotation.

2. The component mounter (10) according to claim 1,
wherein the mounting head (30) has a rotation device (35) configured to rotate the multiple holders (32) in an interlocked fashion.

3. The component mounter (10) according to claim 2,
wherein a required time (Rp1, Rp2, ...) for executing the pickup operation one time is either a required time (Sm11, Sm12, ...) for the pickup movement associated with the pickup operation or a required time (Sr1, Sr2, ...) for the preliminary rotation which is longer,
wherein a required time (Rm1, Rm2, ...) for executing the mounting operation one time is either a required time (Tm1, Tm2, ...) for the mounting movement associated with the mounting operation or a required time (Tr1, Tr2, ...) for the mounting rotation which is longer, the required time (Rc) for the pick-and-place cycle is a sum of required times (Rp1 + Rp2 + ...+ Rm1 + Rm2 + ...) for all the pickup operations and the mounting operations included in the pick-and-place cycle, and
wherein the setting section (24) is configured to set whether the preliminary rotation is to be executed for each of the pickup operations executed multiple times so that the required time (Rc) for the pick-and-place cycle is shortened.

4. The component mounter (10) according to anyone of claims 1 to 3,
wherein when the pickup operation is executed multiple times in the pick-and-place cycle, the mounting control section (22) is configured to move the mounting head (30) in accordance with the components (92) to be a pickup target and the pickup order which are set by the setting section (24) and to rotate the holder (32) in accordance with a rotation amount indicating whether the preliminary rotation is necessary which is set for each of the pickup operations by the setting section (24).

5. The component mounter (10) according to any one of claims 1 to 4,
wherein the holding member (33) is a suction nozzle (33) configured to hold the component (92) by picking up the component (92) through suction using supplied negative pressure air.

6. The component mounter (10) according to any one of claims 1 to 5,
wherein, when setting the components (92) to be a pickup target in a multiplicity of the components (92) supplied to the supply area (As) and a pickup order, the pickup order defining a path for picking up the components (92) set as a pickup target, in the case that there are multiple path candidates (Nr1, Nr2) for picking up the components (92), the setting section (24) is configured to set higher a priority of adoption for the path (Nr1, Nr2) which is more linear.

7. The component mounter (10) according to any one of claims 1 to 6,
wherein the supply area (As) is divided into multiple partitions (S1 - S4),
wherein the state recognition section (23) is configured to execute processing for recognizing the supply state for each of the multiple partitions (S1 - S4) of the supply area (As), and
wherein the setting section (24) is configured to set the components (92) to be a pickup target in a multiplicity of the components (92) supplied to the partition (S1 - S4) in the multiple partitions (S1 - S4) in the supply area (As) for which the supply state is recognized and a pickup order for the partition (S1 - S4).

8. The component mounter (10) according to claim 7,
wherein, in the case that more components (92) are supplied to the supply area than a required number for one pick-and-place cycle,
the mounting control section (22) is configured to execute the pick-and-place cycle after the setting section (24) sets completely a pickup order of the components (92) for at least one of the multiple partitions (S1 - S4), and
the setting section (24) is configured to set pickup orders of the components (92) for use in the pick-and-place cycle which is to be executed subsequently and onward for remaining partitions (S1 - S4) in the multiple partitions (S1 - S4) in parallel with the pick-and-place cycle which is being executed currently.

9. The component mounter (10) according to any one of claims 1 to 8,
wherein the mounting control section (22) is configured to execute the pickup operation multiple times in the pick-and-place cycle in accordance with the components (92) to be a pickup target and the pickup order which are set by the setting section (24).

## Patentansprüche

1. Komponentenmontagegerät (10), das umfasst:
einen Montagesteuerabschnitt (22), der konfiguriert ist, um einen Pick-and-Place-Zyklus auszuführen, der einen Aufnahmevorgang zum Aufnehmen einer Komponente (92) aus einem Bereitstellungsbereich (As) und einen Montagevorgang zum Montieren der Komponente (92) in einer vorgegebenen Montageposition in einem vorgegebenen Montagewinkel auf einer Platine (91) umfasst;
einen Zustandserkennungsabschnitt (23), der konfiguriert ist, um einen Bereitstellungszustand einschließlich Positionen einer Vielzahl der Komponenten (92) zu erkennen;
einen Einstellabschnitt (24), der konfiguriert ist, um die Komponenten (92) aus der Vielzahl der dem Bereitstellungsbereich (As) zugeführten Komponenten (92) als Aufnahmeziel einzustellen und auf der Grundlage der so erkannten Positionen und des Montagewinkels für jeden Montagevorgang, der im Pick-and-Place-Zyklus mehrmals ausgeführt wird, eine Aufnahmereihenfolge einzustellen; und
einen Montagekopf (30), der konfiguriert ist, um sich in dem Komponentenmontagegerät (10) in horizontaler Richtung zu bewegen,
wobei der Montagekopf (30) so konfiguriert ist, dass er mehrere Halter (32) trägt, an denen Halteelemente (33) zum Halten der Komponenten (92) einzeln derart befestigt sind, dass die mehreren Halter (32) nicht nur angehoben und abgesenkt werden können, sondern auch einzeln um ihre eigene Drehachse rotieren können,
wobei der Montagesteuerabschnitt (22) konfiguriert ist
zum Ausführen einer Montagebewegung zum Bewegen des Montagekopfes (30), um das Halteelement (33) von einer aktuellen Position in die Montageposition im Montagevorgang zu bewegen, und einer Montagedrehung zum Drehen des Halters (32), um den Montagewinkel im Montagevorgang des Pick-and-Place-Zyklus einzunehmen,
zum Ausführen einer Aufnahmebewegung um den Montagekopf (30) so zu bewegen, dass das Halteelement (33) von einer aktuellen Position zu einem der Vielzahl der Komponenten (92) im Bereitstellungsbereich (As) bewegt wird, und einer Vordrehung zum Vorabdrehen des Halters (32) entsprechend dem Montagewinkel im Montagevorgang, mit dem die im Aufnahmevorgang aufgenommene Komponente (92) im Aufnahmevorgang des Montagevorgangs im Pick-and-Place-Zyklus auf der Platine (91) montiert wird, und
um die Montagedrehung wegzulassen oder einen Drehbetrag des Halters (32) bei der Montagedrehung entsprechend einem Drehbetrag des Halters (32) bei der Vordrehung zu reduzieren,
**dadurch gekennzeichnet, dass**
die Vielzahl der Komponenten (92) in loser Schüttung dem Bereitstellungsbereich (As) zugeführt wird,
der vom Zustandserkennungsabschnitt (23) erkannte Bereitstellungszustand nicht nur Positionen, sondern auch Orientierungen der Vielzahl von Komponenten (92), die bereitgestellt werden, umfasst,
der Einstellabschnitt (24) weiterhin konfiguriert ist, um die Komponenten (92) als Aufnahmeziel und die Aufnahmereihenfolge nicht nur auf Grundlage der Positionen,
sondern auch auf Grundlage der im erkannten Bereitstellungszustand enthaltenen Orientierungen einstellzustellen,
die Aufnahmereihenfolge festgelegt wird, indem im Voraus ein Montagewinkel für jeden Montagevorgang sowie eine Aufnahmemöglichkeit berücksichtigt werden, so dass eine erforderliche Zeit (Rc) für den Pick-and-Place-Zyklus verkürzt wird,
wobei die erforderliche Zeit (Rc) für den Pick-and-Place-Zyklus die Summe der erforderlichen Zeiten für alle im Pick-and-Place-Zyklus enthaltenen Aufnahmevorgänge und Montagevorgänge ist, und
der Montagesteuerabschnitt (22) ferner dazu ausgelegt ist, bei der Ausführung der Vordrehung die im Bereitstellungszustand enthaltene Orientierung zu berücksichtigen.

2. Komponentenmontagegerät (10) nach Anspruch 1,
wobei der Montagekopf (30) eine Drehvorrichtung (35) aufweist, die dazu konfiguriert ist, die mehreren Halter (32) ineinandergreifend zu drehen.

3. Komponentenmontagegerät (10) nach Anspruch 2,
wobei eine erforderliche Zeit (Rp1, Rp2, ...) zum einmaligen Ausführen des Aufnahmevorgangs entweder eine erforderliche Zeit (Sm11, Sm12, ...) für die mit dem Aufnahmevorgang verbundene Aufnahmebewegung oder eine erforderliche Zeit (Sr1, Sr2, ...) für die Vordrehung ist, je nachdem, welche Zeit länger ist,
wobei eine erforderliche Zeit (Rm1, Rm2, ...) zum einmaligen Ausführen des Montagevorgangs entweder eine erforderliche Zeit (Tm1, Tm2, ...) für die mit dem Montagevorgang verbundene Montagebewegung oder eine erforderliche Zeit (Tr1, Tr2, ...) für die Montagedrehung ist, je nachdem, welche Zeit länger ist,
die erforderliche Zeit (Rc) für den Pick-and-Place-Zyklus eine Summe der erforderlichen Zeiten (Rp1 + Rp2 + ...+ Rm1 + Rm2 + ...) für alle im Pick-and-Place-Zyklus enthaltenen Aufnahmevorgänge und Montagevorgänge ist, und
wobei der Einstellabschnitt (24) so konfiguriert ist, dass er einstellt, ob die Vordrehung für jeden der mehrfach ausgeführten Aufnahmevorgänge ausgeführt werden soll, so dass die erforderliche Zeit (Rc) für den Pick-and-Place-Zyklus verkürzt wird.

4. Komponentenmontagegerät (10) nach einem der Ansprüche 1 bis 3,
wobei, wenn der Aufnahmevorgang mehrmals im Pick-and-Place-Zyklus ausgeführt wird, der Montagesteuerabschnitt (22) so konfiguriert ist, dass er den Montagekopf (30) entsprechend den Komponenten (92), die ein Aufnahmeziel sein sollen und dem Aufnahmereihenfolge, die durch den Einstellabschnitt (24) eingestellt werden, bewegt, und das er den Halter (32) entsprechend einem Drehbetrag dreht, der angibt, ob die Vordrehung erforderlich ist, und der für jeden Aufnahmevorgang durch den Einstellabschnitt (24) eingestellt wird.

5. Komponentenmontagegerät (10) nach einem der Ansprüche 1 bis 4,
wobei das Halteelement (33) eine Saugdüse (33) ist, die konfiguriert ist, um die Komponente (92) zu halten, indem sie die Komponente (92) durch Ansaugen mittels zugeführter Unterdruckluft aufnimmt.

6. Komponentenmontagegerät (10) nach einem der Ansprüche 1 bis 5,
wobei, wenn beim Einstellen der Komponente (92) aus einer Vielzahl der dem Bereitstellungsbereich (As) zugeführten Komponenten (92) als Aufnahmeziel und beim Einstellen einer Aufnahmereihenfolge, wobei die Aufnahmereihenfolge einen Pfad zum Aufnehmen der Komponenten (92) definiert, für den Fall, dass es mehrere Pfadkandidaten (Nr1, Nr2) zum Aufnehmen der Komponenten (92) gibt, der Einstellabschnitt (24) so konfiguriert ist, dass er eine höhere Priorität einstellt für den Pfad (Nr1, Nr2), der linearer ist.

7. Komponentenmontagegerät (10) nach einem der Ansprüche 1 bis 6,
wobei der Bereitstellungsbereich (As) in mehrere Partitionen (S1 - S4) unterteilt ist,
wobei der Zustandserkennungsabschnitt (23) konfiguriert ist, um eine Verarbeitung zum Erkennen des Bereitstellungszustands für jede der mehreren Partitionen (S1-S4) des Bereitstellungsbereichs (As) auszuführen, und
wobei der Einstellabschnitt (24) konfiguriert ist, um die Komponenten (92) aus einer Vielzahl der der Partition (S1-S4) zugeführten Komponenten (92) in den mehreren Partitionen (S1-S4) des Bereitstellungsbereichs (As), für die der Bereitstellungszustand erkannt wird, als Aufnahmeziel einzustellen, und eine Aufnahmereihenfolge für die Partition (S1 - S4) einzustellen.

8. Komponentenmontagegerät (10) nach Anspruch 7,
wobei für den Fall, dass dem Bereitstellungsbereich mehr Komponenten (92) zugeführt sind als für einen Pick-and-Place-Zyklus erforderlich sind,
der Montagesteuerabschnitt (22) so konfiguriert ist, dass er den Pick-and-Place-Zyklus ausführt, nachdem der Einstellabschnitt (24) eine Aufnahmereihenfolge der Komponenten (92) für mindestens eine der mehreren Partitionen (S1-S4) vollständig eingestellt hat, und
der Einstellabschnitt (24) so konfiguriert ist, dass er Aufnahmereihenfolgen der Komponenten (92) zur Verwendung im Pick-and-Place-Zyklus, der anschließend ausgeführt werden soll, und weiter für die verbleibenden Partitionen (S1-S4) aus den mehreren Partitionen (S1 - S4), parallel zum Pick-and-Place-Zyklus, der aktuell ausgeführt wird, einstellt.

9. Komponentenmontagegerät (10) nach einem der Ansprüche 1 bis 8,
wobei der Montagesteuerabschnitt (22) konfiguriert ist, um den Aufnahmevorgang mehrmals im Pick-and-Place-Zyklus entsprechend den Komponenten (92), die ein Aufnahmeziel sein sollen, und der Aufnahmereihenfolge, die vom Einstellabschnitt (24) festgelegt sind, auszuführen.

## Revendications

1. Dispositif de montage de composants (10) comprenant :
une section de commande de montage (22) configurée pour exécuter un cycle de prélèvement et de placement comprenant une opération de prélèvement pour prélever un composant (92) à partir d'une zone d'alimentation (As) et une opération de montage pour monter le composant (92) dans une position de montage prédéterminée à un angle de montage prédéterminé sur une carte (91) ;
une section de reconnaissance d'état (23) configurée pour reconnaître un état d'alimentation comprenant des positions d'une multiplicité des composants (92) ;
une section d'établissement (24) configurée pour établir les composants (92) comme étant une cible de prélèvement dans la multiplicité des composants (92) fournis à la zone d'alimentation (As) et un ordre de prélèvement sur la base des positions ainsi reconnues et de l'angle de montage pour chaque opération de montage qui est exécutée plusieurs fois au cours du cycle de prélèvement et de placement ; et
une tête de montage (30) configurée pour se déplacer dans une direction horizontale à l'intérieur du dispositif de montage de composants (10),
dans lequel la tête de montage (30) est configurée pour soutenir de multiples supports (32) auxquels des éléments de maintien (33) destinés à maintenir les composants (92) sont fixés individuellement de manière à permettre aux multiples supports (32) non seulement d'être levés et abaissés mais aussi de tourner individuellement autour de leurs propres axes de rotation,
dans lequel la section de commande de montage (22) est configurée
pour exécuter un mouvement de montage pour déplacer la tête de montage (30) de manière à déplacer l'élément de maintien (33) d'une position actuelle à la position de montage lors de l'opération de montage et une rotation de montage pour faire tourner le support (32) de manière à prendre l'angle de montage lors de l'opération de montage du cycle de prélèvement et de placement,
pour exécuter un mouvement de prélèvement pour déplacer la tête de montage (30) de manière à déplacer l'élément de maintien (33) d'une position actuelle vers l'un de la multiplicité des composants (92) dans la zone d'alimentation (As) et une rotation préliminaire pour faire tourner à l'avance le support (32) conformément à l'angle de montage lors de l'opération de montage auquel le composant (92) prélevé lors de l'opération de prélèvement est monté sur la carte (19) lors de l'opération de prélèvement du cycle de prélèvement et de placement, et
pour omettre la rotation de montage ou réduire une quantité de rotation du support (32) dans la rotation de montage conformément à une quantité de rotation du support (32) dans la rotation préliminaire,
**caractérisé en ce que**
la multiplicité de composants (92) est fournie dans un état en vrac à la zone d'alimentation (As),
l'état d'alimentation reconnu par la section de reconnaissance d'état (23) comprend non seulement des positions mais également des orientations de la multiplicité de composants (92) qui sont fournis,
la section d'établissement (24) est en outre configurée pour établir les composants (92) comme étant une cible de prélèvement et l'ordre de prélèvement non seulement sur la base des positions mais également sur la base des orientations incluses dans l'état d'alimentation reconnu,
l'ordre de prélèvement est établi en considérant à l'avance un angle de montage pour chaque opération de montage ainsi qu'une possibilité de prélèvement de sorte qu'un temps requis (Rc) pour le cycle de prélèvement et de placement soit raccourci,
dans lequel le temps requis (Rc) pour le cycle de prélèvement et de placement est la somme des temps requis pour toutes les opérations de prélèvement et les opérations de montage incluses dans le cycle de prélèvement et de placement, et
la section de commande de montage (22) est en outre configurée pour prendre en compte l'orientation incluse dans l'état d'alimentation lors de l'exécution de la rotation préliminaire.

2. Dispositif de montage de composants (10) selon la revendication 1,
dans lequel la tête de montage (30) a un dispositif de rotation (35) configuré pour faire tourner les multiples supports (32) de manière imbriquée.

3. Dispositif de montage de composants (10) selon la revendication 2,
dans lequel un temps requis (Rp1, Rp2, ...) pour exécuter l'opération de prélèvement une fois est soit un temps requis (Sm11, Sm12, ...) pour le mouvement de prélèvement associé à l'opération de prélèvement, soit un temps requis (Sr1, Sr2, ...) pour la rotation préliminaire qui est plus long,
dans lequel un temps requis (Rm1, Rm2, ...) pour exécuter l'opération de montage une fois est soit un temps requis (Tm1, Tm2, ...) pour le mouvement de montage associé à l'opération de montage, soit un temps requis (Tr1, Tr2, ...) pour la rotation de montage qui est plus long,
le temps requis (Rc) pour le cycle de prélèvement et de placement est une somme des temps requis (Rp1 + Rp2 + ...+ Rm1 + Rm2 + ...) pour toutes les opérations de prélèvement et les opérations de montage incluses dans le cycle de prélèvement et de placement, et
dans lequel la section d'établissement (24) est configurée pour établir si la rotation préliminaire doit être exécutée pour chacune des opérations de prélèvement exécutées plusieurs fois de sorte que le temps requis (Rc) pour le cycle de prélèvement et de placement soit raccourci.

4. Dispositif de montage de composants (10) selon l'une quelconque des revendications 1 à 3,
dans lequel, lorsque l'opération de prélèvement est exécutée plusieurs fois dans le cycle de prélèvement et de placement, la section de commande de montage (22) est configurée pour déplacer la tête de montage (30) conformément aux composants (92) devant être une cible de prélèvement et à l'ordre de prélèvement qui sont établis par la section d'établissement (24) et pour faire tourner le support (32) conformément à une quantité de rotation indiquant si la rotation préliminaire est nécessaire qui est établie pour chacune des opérations de prélèvement par la section d'établissement (24).

5. Dispositif de montage de composants (10) selon l'une quelconque des revendications 1 à 4,
dans lequel l'élément de maintien (33) est une buse d'aspiration (33) configurée pour maintenir le composant (92) en prélevant le composant (92) par aspiration en utilisant de l'air à pression négative fourni.

6. Dispositif de montage de composants (10) selon l'une quelconque des revendications 1 à 5,
dans lequel, lors de l'établissement des composants (92) comme étant une cible de prélèvement dans une multiplicité des composants (92) fournis à la zone d'alimentation (As) et d'un ordre de prélèvement, l'ordre de prélèvement définissant un chemin pour prélever les composants (92) établis comme étant une cible de prélèvement, dans le cas où il existe de multiples candidats de chemin (Nr1, Nr2) pour prélever les composants (92), la section d'établissement (24) est configurée pour établir une priorité d'adoption plus élevée pour le chemin (Nr1, Nr2) qui est plus linéaire.

7. Dispositif de montage de composants (10) selon l'une quelconque des revendications 1 à 6,
dans lequel la zone d'alimentation (As) est divisée en multiples partitions (S1 - S4),
dans lequel la section de reconnaissance d'état (23) est configurée pour exécuter un traitement pour reconnaître l'état d'alimentation pour chacune des multiples partitions (S1 - S4) de la zone d'alimentation (As), et
dans lequel la section d'établissement (24) est configurée pour établir les composants (92) comme étant une cible de prélèvement dans une multiplicité des composants (92) fournis à la partition (S1 - S4) dans les multiples partitions (S1 - S4) dans la zone d'alimentation (As) pour laquelle l'état d'alimentation est reconnu et un ordre de prélèvement pour la partition (S1 - S4).

8. Dispositif de montage de composants (10) selon la revendication 7,
dans lequel, dans le cas où plus de composants (92) sont fournis à la zone d'alimentation qu'un nombre requis pour un cycle de prélèvement et de placement,
la section de commande de montage (22) est configurée pour exécuter le cycle de prélèvement et de placement après que la section d'établissement (24) a établi complètement un ordre de prélèvement des composants (92) pour au moins une des multiples partitions (S1 - S4), et
la section d'établissement (24) est configurée pour établir des ordres de prélèvement des composants (92) à utiliser dans le cycle de prélèvement et de placement qui doit être exécuté ultérieurement et vers l'avant pour les partitions restantes (S1 - S4) dans les multiples partitions (S1 - S4) en parallèle avec le cycle de prélèvement et de placement qui est en cours d'exécution.

9. Dispositif de montage de composants (10) selon l'une quelconque des revendications 1 à 8,
dans lequel la section de commande de montage (22) est configurée pour exécuter l'opération de prélèvement plusieurs fois dans le cycle de prélèvement et de placement conformément aux composants (92) devant être une cible de prélèvement et à l'ordre de prélèvement qui sont établis par la section d'établissement (24).
